Europäisches Patentamt

European Patent Office

Office européen des brevets

(11) Veröffentlichungsnummer: **0 213 438**

**A2**

(12) **EUROPÄISCHE PATENTANMELDUNG**

(21) Anmeldenummer: 86110818.1

(22) Anmeldetag: 05.08.86

(51) Int. Cl.4: **G02B 21/00** , **H01J 37/28**

(30) Priorität: 30.08.85 DE 3531129

(43) Veröffentlichungstag der Anmeldung:
11.03.87 Patentblatt 87/11

(84) Benannte Vertragsstaaten:
**AT DE FR GB IT NL**

(71) Anmelder: **Siemens Aktiengesellschaft Berlin
und München**
**Wittelsbacherplatz 2**
**D-8000 München 2(DE)**

(72) Erfinder: **Brust, Hans-Detlef**
**Martin-Luther-Strasse 2**
**D-6602 Dudweiler(DE)**
Erfinder: **Otto, Johann, Dipl.-Ing. FH**
**Pater-Hammerschmid-Strasse 4**
**D-8170 Bad Tölz(DE)**

(54) **Verfahren und Anordnung zum Betrieb eines Rastermikroskopes.**

(57) In einem Rastermikroskop, in dem man Bereiche der Oberfläche einer auf ihre elektrischen oder physikalischen Eigenschaften hin zu untersuchenden Probe punktweise mit einer Strahlungs-oder Partikelsonde abtastet, wird die Rastergeschwindigkeit in Abhängigkeit von einem am jeweils beaufschlagten Punkt der Probenoberfläche abgeleiteten sekundären elektrischen Signal gesteuert. Als Steuersignal dient hierbei das in einem Fensterdiskriminator oder Komparator bewertete Ausgangssignal einer Anordnung zur Signalverarbeitung, das man dem VCO (Voltage Controlled Oscillator) des Rastergenerators über ein einstellbares Zeitglied zuführt. Gleichzeitig kann das bewertete Ausgangssignal zur Modulation der Intensität des Schreibstrahles eines Sichtgerätes und zur Steuerung der Intensität der Strahlungs-oder Partikelsonde herangezogen werden.

FIG 3

## Verfahren und Anordnung zum Betrieb eines Rastermikroskopes

Die Erfindung betrifft ein Verfahren zum Betrieb eines Rastermikroskopes, insbesondere eines Raster-Lasermikroskopes nach dem Obergriff des Patentanspruchs 1, und eine Anordnung zur Durchführung des Verfahrens nach dem Oberbegriff des Patentanspruchs 10.

Die Überprüfung der Funktionsweise hochintegrierter Schaltungen erfolgt üblicherweise in rechnergesteuerten Testanlagen. Die in diesen Anlagen mit hohem Zeitaufwand durchgeführten Untersuchungen sind allerdings in den meisten Fällen unvollständig, da vorhandene Fehler durch Analyse der in Abhängigkeit von den jeweils eingespeisten Bitmustern an den Ausgängen der untersuchten Schaltung gemessenen Spannungspegel zwar erkannt, aber nur sehr schwer lokalisiert werden können. Deshalb müssen insbesondere während der Entwicklungsphase zusätzliche Messungen im Inneren hochintegrierter Schaltungen durchgeführt werden. Als für diese Zwecke besonders geeignet haben sich die in allen Bereichen der Entwicklung und Fertigung von mikroelektronischen Bauelementen eingesetzten Elektronenstrahl-Meßverfahren herausgestellt. Diese zumeist mit modifizierten Raster-Elektronenmikroskopen durchgeführten Meßverfahren erfordern allerdings einen hohen apparativen Aufwand und führen insbesondere bei den mit Passivierungsschichten versehenen Bauelementen zu einer die Meßgenauigkeit beeinträchtigenden Aufladung der Probenoberfläche.

Neben Elektronenstrahl-Meßgeräten werden deshalb auch belastungsfrei arbeitende optische Rastermikroskope, insbesondere Raster-Lasermikroskope zur Untersuchung hochintegrierter Schaltungen eingesetzt (R. Müller "Scanning Laser Microscope for Inspection of Microelectronic Devices", Siemens Forschungs-und Entwicklungsberichte Bd. 13 (1984) Nr. 1, Seiten 9 bis 14).

Aufbau und Funktionsweise eines Raster-Lasermikroskopes sind beispielsweise in dem Artikel von V. Wilke "Laser Scanning in Microscopy" in den Proceedings of the International Society for Optical Engineering: Advances in Laser Scanning and Recording, April 19-20, 1983, Genf Schweiz) beschrieben.

Zur Untersuchung einer Probe, insbesondere einer integrierten Schaltung in einem Raster-Lasermikroskop, wird deren Oberfläche punktweise mit einem fein gebündelten Laserstrahl abgetastet, wobei die Wechselwirkung des Laserstrahles mit der Probensubstanz in Halbleiterbauelementen zur Erzeugung von Elektronen-Loch-Paaren führt. Wird der aus der Trennung dieser Elektronen-Loch-Paare im Bereich eines pn-Übergangs resultierende, und in einem äußeren Stromkreis meßbare Photostrom zur Modulation der Intensität eines synchron mit dem Laserstrahl über einen Bildschirm abgelenkten Schreibstrahls einer Kathodenstrahlröhre herangezogen, erhält man eine zweidimensionale Darstellung der pn-Übergänge innerhalb der Schaltung.

Es ist bekannt, daß die möglichen Wechselwirkungen des Primärstrahles mit der Probensubstanz durch dessen Rastergeschwindigkeit beeinflußt werden können. Um sicherzustellen, an jeder Stelle der Probenoberfläche den gewünschten physikalischen Effekt mit Hilfe des Primärstrahls erzeugen und beispielsweise über den Photostrom nachweisen zu können, war man bisher gezwungen, die Probe mit einer sehr geringen Rastergeschwindigkeit abzutasten. Dies führte insbesondere bei mikroelektronischen Bauelementen, die während der Untersuchung mit niedrigen Ansteuerfrequenzen betrieben werden müssen zu sehr langen Bildaufnahmezeiten.

Der Erfindung liegt die Aufgabe zugrunde, ein Verfahren zum Betrieb eines Rastermikroskopes anzugeben, mit dem die Bildaufnahmezeiten reduziert und die für die jeweilige Untersuchung erforderliche Wechselwirkung des Primärstrahles mit der Probe sicher an jedem geeigneten Punkt erzeugt und nachgewiesen werden kann. Es soll außerdem sichergestellt sein, daß sich die mit einer Ansteuerung betriebene Probe zu den jeweiligen Abtastzeitpunkten in dem gleichen definierten Betriebszustand befindet. Dies wird erfindungsgemäß durch ein Verfahren nach dem kennzeichnenden Teil des Patentanspruchs 1 erreicht.

Der mit der Erfindung erzielbare Vorteil besteht insbesondere darin, probenabhängige Bildaufnahmezeiten zu erhalten, diese zu minimieren und die Probe nur im Falle der gewünschten Wechselwirkung besonders ansteuern zu müssen. Zusätzlich kann man die Wechselwirkung mit der Probe über eine Steuerung der Intensität des Primärstrahles auf einen bestimmten wählbaren Zeitraum beschränken, die Probe damit schonen und die Analyse der beispielsweise von einer Signalverarbeitung gelieferten Meßwerte erleichtern.

Die Ansprüche 2 bis 9 sind auf bevorzugte Ausgestaltungen des Verfahrens nach Anspruch 1 gerichtet, während die Ansprüche 10 bis 16 vorteilhafte Anordnungen zur Durchführung des Verfahrens betreffen.

Die Erfindung wird nachfolgend anhand der Zeichnungen näher erläutert. Dabei zeigt:

Fig. 1 den Strahlengang in einem Raster-Lasermikroskop

Fig. 2 eine erste Anordnung zur Durchführung des erfindungsgemäßen Verfahrens

Fig. 3 eine zweite Anordnung zur Durchführung des erfindungsgemäßen Verfahrens

Fig. 4 eine Teilschaltung der Anordnung nach Fig. 3

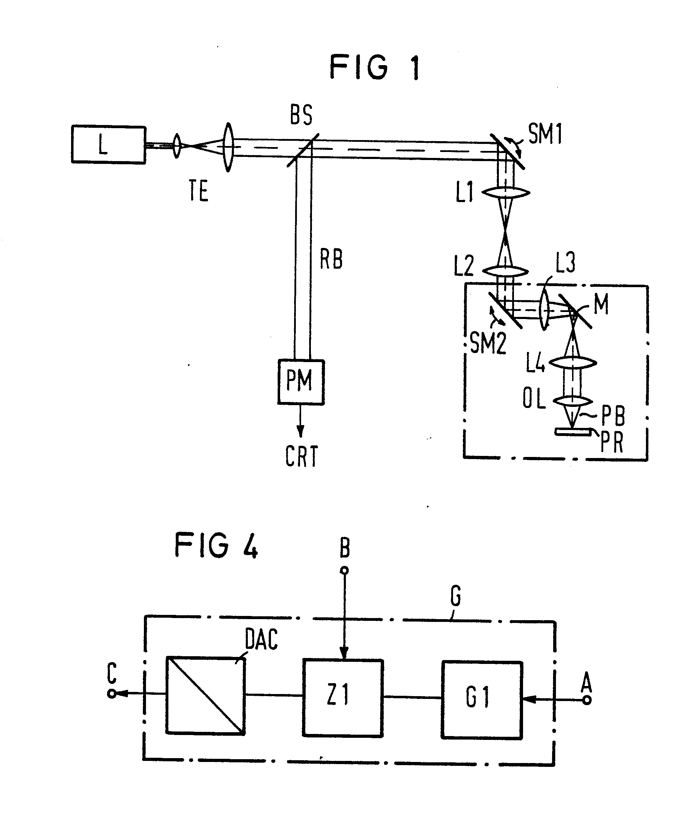

Der Strahlengang eines optischen Rastermikroskops ist schematisch in Fig. 1 dargestellt. In optischen Rastermikroskopen werden üblicherweise im Wellenlängenbereich des sichtbaren Lichtes arbeitende Laser L als intensitätsstarke Strahlungsquellen eingesetzt. Laser als Lichtquellen bieten unter anderem den Vorteil, daß sich deren Strahlung infolge des hohen Kollimationsgrades auch bei langen Strahlwegen innerhalb der Anordnung durch eine gute Fokussierbarkeit auszeichnet. Zur Erzeugung eines feinen Primärstrahles PB auf der zu untersuchenden Probe PR wird der als Sonde dienende Laserstrahl über ein System aus Spiegeln M, Scannern SM1 und SM2 und Linsen L1 bis L4 in die Eintrittspupille der Objektivlinse OL eingekoppelt. Hierzu muß der Strahl zunächst mit Hilfe eines Teleskopes TE aufgeweitet und dem Durchmesser der Eintrittspupille der Objektivlinse OL angepaßt werden. Anschließend wird der Strahl über eine beispielsweise aus zwei hochgenauen Spiegelgalvanometern SM1 und SM2 bestehenden Rastereinheit geführt. Um sicherzustellen, daß der Laserstrahl in der Objektivpupille örtlich ruht, d. h. nur eine Winkelbewegung mit der Pupille als Drehpunkt ausführt, werden die um orthogonale Achsen schwingenden Spiegel SM1 und SM2 der beiden Galvanometer mit einer telezentrischen Optik L1 bis L4 in die Eintrittspupille der Objektivlinse OL abgebildet. Das punktweise Abtasten der Probe PR mit dem von der Objektivlinse OL auf die Probenoberfläche fokussierten, und in seinem Durchmesser reduzierten Laserstrahl PB erfolgt durch eine geeignete Ansteuerung der Rastereinheit SM1 und SM2 über einen in Fig. 1 nicht dargestellten digitalen Rastergenerator.

Um ein Bild der Probe zu erhalten, kann man beispielsweise die von der Probenoberfläche reflektierte Strahlung einem Detektor zuführen. Zur Erzeugung des sog. Auflichtbildes wird die in die Objektivlinse OL rückgestreute und über die Rastereinheit SM1 und SM2 und einen halbdurchlässigen Spiegel BS ausgekoppelte Strahlung RB beispielsweise in einem Photomultiplier PM detektiert, dessen Ausgangssignal die Intensität eines synchron mit der Lasersonde PB über den Bildschirm abgelenkten Schreibstrahles des Sichtgerätes CRT moduliert.

Neben diesen konventionellen lichtmikroskopischen Untersuchungen bietet das optisches Rastermikroskop wie auch das Raster-Elektronenmikroskop die Möglichkeit, hochintegrierte Schaltungen auf ihre Funktionstüchtigkeit zu überprüfen, bzw. Qualitätskontrollen durchzuführen. Dies geschieht beispielsweise mit einem als OBIC (Optical Beam Induced Current) bezeichneten Verfahren (bzw. EBIC bei Verwendung einer Elektronensonde), das zur Darstellung der mit Hilfe der Lasersonde in einer Schaltung induzierten Stromverteilung und damit zur Darstellung der pn-Übergänge verwendet wird. Durch eine geeignete Ansteuerung der Schaltung lassen sich auch logische Zustände darstellen bzw. optisch unsichtbare Oberflächeneffekte oder Unterbrechungen erkennen.

Von besonderem Interesse für den Entwickler von integrierten Schaltungen ist die Untersuchung von CMOS-Strukturen auf ihr Verhalten gegenüber dem sog. Latch-up-Effekt. Auf die physikalischen Ursachen und den Nachweis des Latch-up-Effektes in CMOS-Schaltungen wird ausführlich in der bereits zitierten Druckschrift von R. Müller eingegangen (siehe hier insbesondere Abschnitt 2, "Investigation of Latch-up Effect", Seite 12 bis 14). Im Normalbetrieb von CMOS-Schaltungen können Latch-up-Effekte durch thermische Generation von Elektronen-Loch-Paaren oder durch ionisierende Strahlung (z.B. Alpha-Strahlung) ausgelöst werden, die u.U. zu einer Zerstörung des Bauelementes führen. Man versucht daher, die Schwachstellen einer CMOS-Schaltung, die eine besonders hohe Latch-up-Empfindlichkeit aufweisen, aufzufinden und in einem Redesign zu verbessern.

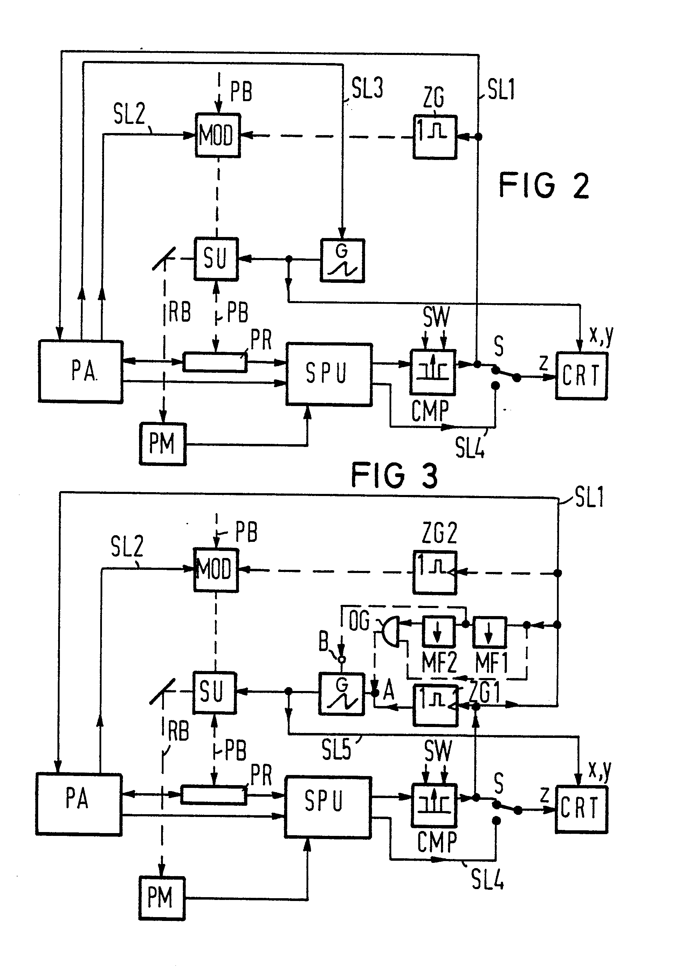

Anhand der in Fig. 2 dargestellten erfindungsgemäßen Anordnung soll im folgenden am Beispiel der Untersuchung einer CMOS-Schaltung auf ihr Verhalten gegenüber Latch-up erläutert werden, wie in einem Raster-Lasermikroskop mit Hilfe des erfindungsgemäßen Verfahrens die für solche Untersuchungen notwendige Wechselwirkung - (Zünden von npnp-bzw. pnpn-Strukturen durch Erzeugung von Elektronen-Loch-Paaren) des Primärstrahles PB mit der Probe PR (integrierte, mit Nennfrequenz arbeitende CMOS-Schaltung) sicher an jedem Punkt erzeugt und nachgewiesen werden kann, und wie sichergestellt wird, daß sich die Probe PR zu den jeweiligen Abtastzeitpunken in dem gleichen definierten Betriebszustand befindet.

Das erfindungsgemäße Verfahren ist selbstverständlich nicht auf diesen Anwendungsfall beschränkt, sondern ist überall dort anwendbar, wo die beim Abtasten einer Probe mit einem rasternden Primärstrahl aufgrund dessen Wechselwirkung mit der Probe ableitbaren sekundären Signale zur Steuerung der Rastergeschwindigkeit herangezogen werden können. Dies gilt insbesondere für die bereits erwähnten OBIC-bzw. EBIC-Untersuchungen an mikroelktronischen Bauelementen, bei denen beispielsweise der in einem äußeren Stromkreis meßbare Photostrom die Abtastgeschwindigkeit steuern kann.

In Fig. 2 ist nochmals stark vereinfacht der sondenformende Teil eines Raster-Lasermikroskopes nach Fig. 1 dargestellt. Die von einem Laser erzeugte, nahezu monochromatische Strahlung wird über eine Rastereinheit SU zeilenweise über die Oberfläche der auf ihr Verhalten gegenüber Latch-up zu untersuchenden, mit Nennfrequenz arbeitenden CMOS-Schaltung PR abgelenkt. Im Strahlengang zwischen Laser und Rastereinheit SU ist hierbei vorteilhafterweise ein in Fig. 1 nicht dargestellter Modulator MOD zur Veränderung der Strahlintensität angeordnet. Die am jeweiligen Auftreffpunkt durch die Wechselwirkung des Laserstrahles PB mit dem Halbleitermaterial erzeugten, und im Bereich eines pn-Übergangs getrennten Elektronen-Loch-Paare führen zu einer Erhöhung des Versorgungsstroms und damit zu einem in der Signalverarbeitung SPU meßbaren Strom. In den Bereichen des Halbleiterbauelementes PR, in denen aufgrund der Schaltungsstruktur oder des Designs hohe Feldstärken bzw. Feldgradienten auftreten, können die optisch erzeugten Ladungsträgerpaare zur Zündung von pnpn-bzw. npnp-Strukturen bzw. zur Durchschaltung von Transistoren führen. Das Zünden thyristorähnlicher Strukturen führt zu einer stark erhöhten Stromaufnahme, damit zu einer starken lokalen Aufheizung und schließlich zur Zerstörung der Schaltung PR. Der Lokalisierung solcher Schwachstellen kommt deshalb besonders während der Entwicklungsphase einer CMOS-Schaltung entscheidende Bedeutung zu.

Latch-up-Effekte lassen sich ebenso wie das Durchschalten eines Transistors durch eine erhöhte Stromaufnahme mit der Signalverarbeitung SPU nachweisen. Während das Auftreten von Latch-up als selbsterhaltendem Effekt unabhängig von der Intensität der Lasersonde PB nur durch Reduktion der Versorgungsspannung unter einen Schwellenwert beseitigt werden kann, geht ein Transistor bei verringerter Strahlintensität wieder in den Sperrzustand über. Latch-up-Untersuchungen sind im allgemeinen an der mit Nennfrequenz arbeitenden CMOS-Schaltung PR durchzuführen. In der Schaltung PR läßt man deshalb Testprogramme abarbeiten, die man über eine Ansteuerung PA, die auch die zum Betrieb des Bauelementes PR notwendige Versorgungsspannungen liefert, zyklisch eingespeist.

Das Auftreten von Latch-up hängt im allgemeinen vom Betriebszustand der Schaltung PR ab. Um sicherzustellen, daß sich die zu untersuchende CMOS-Schaltung PR zu dem jeweiligen Abtastzeitpunkt unabhängig vom Abtastort auf der Oberfläche im gleichen definierten Betriebszustand befindet, wird der die Ablenkspannung für die Rastereinheit SU erzeugende Rastergenerator G von der Probenansteuerung PA über die Signalleitung SL3 erst dann zum Positionieren der Lasersonde PB auf den nächsten Meßpunkt veranlaßt, wenn mindestens ein Zyklus oder der interessierende Teil eines Zyklus des eingespeisten Testprogrammes vollständig abgearbeitet ist. Daneben ist es möglich, die Lasersonde PB über die Signalleitung SL2 durch ein Freigabesignal der Probenansteuerung PA an den Modulator MOD während des Abarbeitens bestimmter Programmteile auszuschalten bzw. die Intensität der Sonde zu verringern und so die Schaltung PR zu schonen oder eine ungewollte, beispielsweise den Schaltungszustand eines Transistors in unerwünschter Weise ändernde Wechselwirkung, zu vermeiden. Wie eingangs beschrieben, können thyristorähnliche Strukturen in Halbleiterbauelementen durch optische Erzeugung von Ladungsträgerpaaren gezündet bzw. Transistoren durchgeschaltet werden. Beide Effekte führen zu einer deutlich erhöhten Stromaufnahme und damit zu einem hohen Ausgangssignal am Ausgang der Signalverarbeitung SPU, das anschließend in einem nach geschalteten Komparator CMP mit vorgegebenen Schwellenwerten SW verglichen und bewertet wird. Anstelle des Komparators CMP kann man beispielsweise auch einen Fensterdiskriminator verwenden. Über die Signalleitung SLI wird das zur Modulation der Intensität des Schreibstrahls des Sichtgerätes CRT herangezogene Ausgangssignal des Komparators CMP auch einem Eingang der Probenansteuerung PA zugeführt. Liegt das Ausgangssignal der Signalverarbeitung SPU unterhalb des vorgegebenen Schwellenwertes SW, wird der Rastergenerator G von der Probenansteuerung PA über die Signalleitung SL3 veranlaßt, die Lasersonde PB nach dem Abarbeiten des Testprogrammes auf dem nächsten Meßpunkt zu positionieren. Überschreitet hingegen der an einem Punkt der Schaltung PR gemessene Signalpegel den betreffenden Schwellenwert SW, bleibt die Lasersonde PB solange auf dem betreffenden Meßpunkt positioniert, bis die nachfolgend beschriebenen Verfahrensschritte vollständig abgearbeitet sind. Erst dann gibt die Probenansteuerung PA über die Signalleitung SL3 den Rastergenerator G zum Anfahren des nächsten Meßpunktes frei.

Um zwischen dem Zünden thyristorähnlicher Strukturen und dem Durchschalten eines Transistors zu unterscheiden, muß die Lasersonde PB ausgeschaltet bzw. deren Intensität reduziert werden, indem man das bewertete Ausgangssignal der Signalverarbeitung SPU über das einstellbares Zeitglied ZG dem Intensitätsmodulator MOD zuführt. Liefert die Signalverarbeitung SPU trotz reduzierter Strahlintensität weiter ein über dem Schwellenwert SW liegendes Ausgangssignal, muß an dem betreffenden Meßpunkt Latch-up aufgetreten sein, und das Ausgangssignal kann zur Modulation der Intensität des synchron mit der Lasersonde PB über den Bildschirm abgelenkten Schreibstrahls des Sichtgerätes CRT herangezogen werden.

Zur Löschung der durch die Lasersonde PB induzierten Zündung einer thyristorähnlichen Struktur wird die Probensteuerung PA über die Signalleitung SL1 veranlaßt, die Versorgungsspannung zu verringern, diese nach erfolgter Unterdrückung der Zündung wieder auf den gewünschten Sollpegel hochzufahren und die Schaltung PR in den gewünschten Betriebszustand zu bringen. Während dieser Zeit besteht wieder die Möglichkeit über die Signalleitung SL2 die Intensität des Primärstrahles PB zu verringern. Befindet sich die zu untersuchende Schaltung PR wieder in dem gewünschten Betriebszustand, und ist mindestens ein Zyklus oder der interessierende Teil eines Zyklus des Testprogramms vollständig abgearbeitet, gibt die Ansteuerung PA den Rastergenerator G über die Steuerleitung SL3 frei, so daß dieser den Primärstrahl PB auf dem nächsten Meßpunkt positioniert. In Abhängigkeit von dem bewerteten Ausgangssignal der Signalverarbeitung SPU werden hier wieder die oben beschriebenen Verfahrensschritte abgearbeitet oder man positioniert die Lasersonde PB nach Beendigung mindestens eines Zyklus des Testprogrammes sofort auf den nächsten Meßpunkt.

Die Lokalisierung der Bereiche in denen Latch-up auftritt wird wesentlich erleichtert, wenn man während der Messung auch das Bild der Schaltung PR im reflektierten Licht aufzeichnet und gleichzeitig auf dem Bildschirm des Sichtgerätes CRT darstellt. In Fig. 2 ist dies schematisch durch den aus Fig. 1 bekannten Auflichtstrahlengang RB und die mit dem Sichtgerät CRT über den Schalter S verbundenen Steuerleitung SL4 der Signalverarbeitung SPU angedeutet.

Der mit dem erfindungsgemäßen Verfahren erzielbare Vorteil liegt insbesondere darin, daß nur Bereiche der Schaltung PR, in denen Latch-up auftritt mit geringer, nicht interessierende Bereiche aber mit erhöhter Ge schwindigkeit abgetastet werden. Im Vergleich zu bekannten Anordnungen verringert sich hierdurch die Bildaufnahmezeit bei gleicher Ortsauflösung und Empfindlichkeit erheblich.

Ist aus technischen Gründen keine Ansteuerung des Rastergenerators G über die Probenansteuerung PA möglich, muß sichergestellt sein, daß der beschriebene Testzyklus (Programmschleife abarbeiten bzw. beim Auftreten von Latch-up zusätzlich auch Verringerung der Strahlintensität und der Versorgungsspannung bzw. Hochfahren der Versorgungsspannung auf die Sollwerte etc.) an jedem Meßpunkt der Probenoberfläche mindestens einmal vollständig abgearbeitet wurde. Dies wird erfindungsgemäß durch eine Anordnung nach Fig. 3 erreicht, in der gleiche Bezugzeichen die gleichen Anordnungselemente wie in Fig. 2 bezeichnen. Im Unterschied zu der in Fig. 1 dargestellten Anordnung erfolgt die Steuerung der Verweildauer der Lasersonde PB auf dem betreffenden Messpunkt und damit die Rastergeschwindigkeit in Abhängigkeit von dem beobachteten Effekt (Latch-up bzw. kein Latch-up) und dem daraufhin durchzuführenden Testzyklus, nicht über ein von der Probenansteuerung PA erzeugtes Signal, sondern über das bewertete Ausgangssignal der Signalverarbeitung SPU, das man dem VCO (Voltage Controlled Oscillator) des Rastergenerators G über das einstellbare Zeitglied ZGI zuführt. Hierdurch wird der Rastergenerator G immer dann von einer ersten, auf eine niedrigere zweite Abtastgeschwindigkeit umgeschaltet, wenn das Ausgangssignal der Signalverarbeitung SPU den im Komparator CMP vorgegebenen Schwellenwert SW, beispielsweise beim Zünden thyristorähnlicher Strukturen, überschreitet. Liegt hingegen das an dem betreffenden Meßpunkt registrierte Ausgangssignal unterhalb dieses Schwellenwertes SW, bleibt die Abtastgeschwindigkeit unverändert. Die von der Abtastgeschwindigkeit abhängige Verweildauer des Primärstrahles PB auf einem Messpunkt muß im Falle einer erhöhten Stromaufnahme der CMOS-Schaltung PR über die niedrige zweite Abtastgeschwindigkeit hierbei so vorgegeben sein, daß sicher zwischen dem Zünden thyristorähnlicher Strukturen und dem Durchschalten von Transistoren unterschieden werden kann. Auf die einzelnen Verfahrensschritte zum Nachweis des Latch-up-Effektes wurde bereits ausführlich im Zusammenhang mit der in Fig. 2 dargestellten Anordnung eingegangen. Um sicherzustellen, daß der durch diese Verfahrensschritte definierte Testzyklus mindestens einmal vollständig abgearbeitet wurde, sollte die Verweildauer $t^{(2)}_{PB}$ des Primärstrahles PB auf dem betreffenden Meßpunkt um mindestens dem Faktor 2 größer gewählt werden als die zur Durchführung des Testzyklus - (Versorgungsspannung und Strahlintensität verringern etc.) notwendige Zeit $t_Z (t^{(2)}_{PB} \approx 2t_Z)$. Entsprechendes gilt für Meßpunkte, an denen man keine erhöhte Stromaufnahme beobachtet. An diesen Punkten wird die durch die hohe Abtastgeschwindigkeit festgelegte Verweildauer $t^{(1)}_{PB}$ so vorgegeben, daß das in die Schaltung PR eingespeiste Testprogramm mindestens einmal vollständig abgearbeitet werden kann. Aus Gründen der Sicherheit sollte auch hier die Verweildauer $t^{(1)}_{PB}$ um den Faktor 2 größer als die zum Abarbeiten des Testprogramms notwendige Zeit $t_{TP}$ gewählt werden $(t^{(1)}_{PB} \approx 2t_{TP})$.

Wegen der fehlenden Synchronisation des Rasterns und des Ansteuerns müssen mit der Anordnung nach Fig. 3 längere Bildaufnahmezeiten in Kauf genommen werden. Während der Positionswechsels des Primärstrahls PB bei der Anordnung nach Fig. 2 genau nach Ablauf der zur Durchführung des Testzyklus oder des Testprogrammes notwendigen Zeit $t_Z$ bzw. $t_{TP}$ erfolgt, muß der Primärstrahl PB bei der Anordnung nach Fig.3 für den gleichen Testzyklus bzw. das gleiche Testprogramm um etwa einen Faktor 2 länger auf den jeweiligen Meßpunkt positioniert bleiben. Trotz dieser Einschränkung bleibt die Bildaufnahmezeit deutlich unter derjenigen bekannter Anordnung, da man nur die Bereiche, in denen der zu untersuchende Effekt (hier Latch-up) auftritt, mit niedrigen Rastergeschwindigkeiten abtastet.

Nach einer bevorzugten Weiterbildung der Anordnung nach Fig. 3 wird das bewertete Ausgangssignal der Signalverarbeitung SPU dem ersten Eingang eines ODER-Gatters OG zugeführt, dessen Ausgang mit dem Steuereingang A des Rastergenerators G verbunden ist. In diesem Fall, wird das bewertete Ausgangssignal auch dem Takteingang des Monoflops MF1 zugeführt, dessen Ausgang mit dem Takteingang eines zweiten Monoflops MF2 und dem die Bewegungrichtung der Lasersonde PB auf der CMOS-Schaltung PR umkehrenden Eingang B des Rastergenerators G verbunden ist. Das Ausgangssignal des Monoflops MF2 führt man schließlich dem zweiten Eingang des ODER-Gatters OG zu. Sobald das Ausgangssignal der Signalverarbeitung SPU den vorgegebenen Schwellenwert SW überschreitet, kippt das Monoflop MF1 um, und liefert an dessen Ausgang ein Signal, das am Eingang B des Rastergenerators G eine Umkehrung der Abtastrichtung der Lasersonde PB und über die Signalleitung SL5 auch eine Umkehrung der Laufrichtung des Schreibstrahls des Sichtgerätes CRT bewirkt. Das Ausmaß des Rücksprungs der Lasersonde PB und des Schreibstrahles des Sichtgerätes CRT ist hierbei von der Länge des vom Monoflop MF1 erzeugten Ausgangssignals bestimmt. Dieser Rücksprung wird vorteilhafter Weise mit der hohen ersten Rastergeschwindigkeit vorgenommen. Gegebenenfalls kann das Sichtgerät CRT während des Rücksprungs dunkelgetastet werden. Nach Beendigung des Rücksprungs werden die Lasersonde PB und der Schreibstrahl des Sichtgerätes CRT wieder in Vorwärts-Richtung abgelenkt, wobei das durch die Flanke des vom Monoflop MF1 erzeugten Ausgangssignals gekippte Monoflop MF2 innerhalb seiner Eigenzeit ein Signal abgibt, das über das ODER-Gatter OG dem Steuereingang A des Rastergenerators G zugeführt wird, und diesen auf die niedrigere zweite Abtastgeschwindigkeit umschaltet, auch wenn das Ausgangssignal der Signalverarveitung SPU infolge dieses Rücksprunges nicht mehr oberhalb des Schwellenwertes SW liegt.

Durch diese Weiterbildung kann vermieden werden, daß der Primärstrahl PB infolge der hohen Abtastgeschwindigkeit beim Erreichen derjenigen Bereiche der CMOS-Schaltung PR in denen Latch-up auftritt, die Grenzen dieser Bereiche in der Darstellung auf dem Bildschirm des Sichtgerätes CRT nur ungenau wiedergibt.

Nach einer bevorzugten Ausgestaltung des Verfahrens nach der Erfindung, werden die während einer ersten schnellen Abtastung eines größeren Oberflächenbereiches der zu untersuchenden Schaltung PR an den einzelnen Mespunkten gewonnenen Ausgangssignale der Signalverarbeitung SPU, beispielsweise in einem Rechner zwischengespeichert. Nach dieser schnellen Übersichtsmessung werden die Bereiche, in denen eine erhöhte Stromaufnahme der Schaltung PR nachweisbar war nochmals mit der niedrigeren zweiten Rastergeschwindigkeit abgetastet und auf dem Bildschirm des Sichtgerätes CRT dargestellt.

Eine zweckmäßige Teilschaltung des Rastergenerators G ist in Fig. 4 dargestellt. Diese besteht aus einem Taktoszillator G1, der durch ein an dem Eingang A anliegendes Signal in seiner Taktfrequenz beeinflußt wird. Diesen Taktoszillator G1 kann man auch als spannungsgesteuerten Oszillator VCO (Voltage Controlled Oscillator) bezeichnen. Ein nachgeschalteter Zähler Z1 zählt die von den Taktoszillator G1 abgegebenen Impulse, wobei über einen DigitalAnalog-Wandler DAC ein dem jeweiligen Zählergebnis amplitudenmäßig entsprechendes analoges Signal abgeleitet wird. Dieses Signal stellt dann bei periodischer Rücksetzung des Zählers Z1 auf einen Anfangswert eine sägezahnförmige Ablenkspannung dar, die über den Ausgang C abgegeben wird. Zur Umkehrung der Ablenkrichtung des Rrimärstrahles PB auf der Probenoberfläche steuert man den Rastergenerator G über dessen Eingang B mit einer, die Zählrichtung des Zählers Z1 umkehrenden Signal an.

Zweckmäßigerweise enthält der Rastergenerator G für die Erzeugung der X-Ablenkspannung und der Y-Ablenkspannung jeweils eine Schaltung der in Fig. 4 dargestellten Art.

## Ansprüche

1. Verfahren zum Betrieb eines Rastermikroskopes, insbesondere eines Raster-Lasermikroskopes, bei dem Bereiche der Oberfläche einer auf ihre elektrischen oder physikalischen Eigenschaften hin zu untersuchenden Probe (PR) punktweise mit einem im sondenformenden Teil des Rastermikroskopes erzeugten und mit Hilfe einer Ablenkeinheit - (SU) über die Probenoberfläche geführten Strahlungs-oder Partikelsonde (PB) abgetastet werden, bei dem die durch die Wechselwirkung der Strahlungs-oder Partikelsonde (PB) am jeweils beaufschlagten Punkt der Probenoberfläche ausgelösten, die zu untersuchenden elektrischen oder physikalischen Eigenschaften charakterisierenden Effekte, in ein elektrisches Signal umgewandelt werden und bei dem dieses Signal einer Anordnung zur Signalverarbeitung (SPU) zuführt wird, dadurch **gekennzeichnet**,

-daß die Probe (PR) in einen definierten, der Untersuchung der jeweiligen elektrischen oder physikalischen Eigenschaften angepaßten Betriebszustand versetzt wird, daß das an dem beaufschlagten Punkt der Probenoberfläche von der Anordnung zur Signalverarbeitung (SPU) erzeugte Ausgangssignal bewertet wird, und daß die Rastergeschwindigkeit und/oder die Intensität der Strahlungs-oder Partikelsonde (PB) in Abhängigkeit von dem bewerteten Ausgangssignal der Anordnung zur Signalverarbeitung (SPU) gesteuert wird.

2. Verfahren nach Anspruch 1, dadurch **gekennzeichnet**,

-daß Bereiche der Probenoberfläche, in denen der die jeweils zu untersuchenden elektrischen oder physikalischen Eigenschaften charakterisierende Effekt nicht auftritt, mit einer ersten Rastergeschwindigkeit, Bereiche in denen dieser Effekt auftritt, mit einer niedrigeren zweiten Rastergeschwindigkeit abgetastet werden.

3. Verfahren nach einem der Ansprüche 1 oder 2, dadurch **gekennzeichnet** ,

-daß die Strahlungs-oder Partikelsonde (PB) solange auf dem jeweils beaufschlagten Punkt der Probenoberfläche positioniert bleibt, bis sichergestellt ist, daß mindestens ein oder ein Teil eines Testzyklus zum eindeutigen Nachweis des die jeweils zu untersuchenden elektrischen oder physikalischen Eigenschaften charakterisierenden Effektes vollständig abgearbeitet ist.

4. Verfahren nach einem der Ansprüche 1 bis 3, dadurch **gekennzeichnet**,

-daß ein Positionswechsel der Strahlungs-oder Partikelsonde (PB) von einem ersten auf einem zweiten Punkt der Probenoberfläche erst dann vorgenommen wird, wenn genau ein oder ein Teil eines Testzyklus zum eindeutigen Nachweis des die jeweils zu untersuchenden elektrischen oder physikalischen Eigenschaften charakterisierenden Effektes vollständig abgearbeitet ist und sich die Probe wieder in dem gleichen definierten Betriebszustand befindet.

5. Verfahren nach Anspruch 4, dadurch **gekennzeichnet**, -daß eine Probenansteuerung (PA) den Betriebszustand der Probe (PR) einstellt und überwacht, und daß der Positionswechsel der Strahlungs-oder Partikelsonde (PB) durch ein in Abhängigkeit von dem bewerteten Ausgangssignal der Signalverarbeitung (SPU) erzeugten Signal der Probenansteuerung (PA) ausgelöst wird.

6. Verfahren nach einem der Ansprüche 1 bis 5, dadurch **gekennzeichnet**,

-daß die Bewegungsrichtung der mit der ersten Rastergeschwindigkeit über die Probenoberfläche abgelenkten Strahlungs-oder Partikelsonde (PB) beim Erreichen der Bereiche, in denen der die zu untersuchenden elektrischen oder physikalischen Eigenschaften charakterisierende Effekt auftritt, kurzzeitig umgekehrt wird, und daß die Strahlungsoder Partikelsonde nach erfolgter Bewegungsumkehr mit der niedrigen zweiten Rastergeschwindigkeit wieder in die ursprüngliche Bewegungsrichtung abgelenkt wird.

7. Verfahren nach einem der Ansprüche 1 bis 6, dadurch **gekennzeichnet**,

-daß die Probenoberfläche von der mit der ersten Rastergeschwindigkeit abgelenkten Strahlungs-oder Partikelsonde (PB) abgetastet wird, daß das an den beaufschlagten Punkten der Probenoberfläche von der Anordnung zur Signalverarbeitung (SPU) erzeugte Ausgangssignal zwischengespeichert wird, und daß anhand der zwischengespeicherten Ausgangssignale Bereiche bestimmt werden, die anschließend ein zweites Mal von der mit der niedrigeren zweiten Rastergeschwindigkeit abgelenkten Strahlungs-oder Partikelsonde (PB) abgetastet werden.

8. Verfahren nach einem der Ansprüche 1 bis 7, dadurch **gekennzeichnet**,

-daß die Bewertung des von der Anordnung zur Signalverarbeitung (SPU) erzeugten Ausgangssignals durch Vergleich mit mindestens einem, von den jeweils zu untersuchenden elektrischen oder physikalischen Eigenschaften abhängigen Schwellwert vorgenommen wird.

9. Verfahren nach einem der Ansprüche 1 bis 8, dadurch **gekennzeichnet**, daß ein Ausgangssignal der Anordnung zur Signalverarbeitung (SPU) aufgezeichnet und/oder auf einem Sichtgerät - (CRT) dargestellt wird.

10. Anordnung zur Durchführung des Verfahrens nach einem der Ansprüche 1 bis 9

mit dem Rastermikroskop, einem Rastergenerator -

(G) der Probenansteuerung (PA) und der Anordnung zur Signalverarbeitung (SPU), dadurch **gekennzeichnet,**

-daß der Anordnung zur Signalverarbeitung (SPU) eine Schwellwertschaltung (CMP) nachgeschaltet ist, daß das von der Schwellwertschaltung (CMP) erzeugte Ausgangssignal über eine erste Signalleitung (SL1) einem Eingang der Probenansteuerung (PA) zugeführt wird.

11. Anordnung nach Anspruch 10, dadurch **gekennzeichnet,**

-daß ein von der Probenansteuerung (PA) in Abhängigkeit von dem Ausgangsignal der Schwellwertschaltung (CMP) erzeugtes Ausgangssignal über eine zweite Signalleitung (SL2) einer Anordnung (MOD) zur Modulation der Intensität der Strahlungs-oder Partikelsonde (PB) zugeführt wird.

12. Anordnung nach Anspruch 10 oder 11 dadurch **gekennzeichnet,**

-daß der Ausgang der Schwellwertschaltung - (CMP) über ein einstellbares Zeitglied (ZG1) mit dem Eingang (A) des Rastergenerators (G) zur Umschaltung von einer ersten auf eine zweite niedrigere Rastergeschwindigkeit verbunden ist.

13. Anordnung nach einem der Ansprüche 10 bis 12, dadurch **gekennzeichnet,**

-daß der Ausgang der Schwellwertschaltung (CMP) mit einem Steuereingang des Rastergenerators (G) für eine zeitlich begrenzte Umkehrung der Abtastrichtung und ein sich dieser Umkehrung anschließendes Rückschalten in die ursprüngliche Abtastrichtung verbunden ist, wobei zusammen mit diesem Rückschalten die Umschaltung auf die niedrigere zweite Rastergeschwindigkeit erfolgt.

14. Anordnung nach Anspruch 10 oder 11 dadurch **gekennzeichnet,**

-daß ein zweites, von der Probenansteuerung (PA) in Abhängigkeit von dem Ausgangsignal der Bewerteschaltung (CMP) erzeugtes Ausgangssignal über eine dritte Signalleitung (SL3) einem Steuereingang des Rastergenerators (G) zugeführt wird.

15. Anordnung nach einem der Ansprüche 10 bis 14, dadurch **gekennzeichnet,**

-daß der Rastergenerator (G) mit den Ablenkeinrichtungen für den Schreibstrahl eines Sichtgerätes (CRT) verbunden ist, dessen Eingang zur Steuerung der Intensität des Schreibstrahles über einen Umschalter (S) wahlweise mit dem Ausgang der Schwellwertschaltung (CMP) und mit einem Topographiesignal oder einem sekundären elektrischen Signal beschaltbar ist.

16. Anordnung nach einem der Ansprüche 10 bis 15 , dadurch **gekennzeichnet,**

-daß der Rastergenerator (G) ein den jeweils abgetasteten Punkt definierendes Positionssignal liefert, das zusammen mit dem Ausgangssignal der Anordnung zur Signalverarbeitung (SPU) einer Aufzeichnungseinrichtung, insbesondere einem Rechner, zugeführt wird.

FIG 1

FIG 4

FIG 2

FIG 3